# EUROPEAN PATENT APPLICATION

(11) **EP 2 905 426 A1**
(43) Date of publication of application: **12.08.2015**
(21) Application number: 14154666.3
(22) Date of filing: 11.02.2014
(51) Int. Cl.: F01D 5/28, C23C 28/00, F01D 11/12

(54) **Component with an abradable coating and a method for coating the abradable coating**

(71) Applicant: Siemens Aktiengesellschaft, 80333 München (DE)
(72) Inventor: Ahmad, Fathi, 41564 Kaarst (DE)

(57) **Abstract**

The invention relates to a component (1) for a turbomachine, the component (1) comprising a coating for minimizing thermal gradients within the component (1), the coating comprising a first coating (2) on at least a portion of a surface of the component, wherein the first coating is substantially free from rhenium. Further, the component (1) includes a second coating (4) on the first coating (2). The second coating (4) includes Rhenium for better thermal resistance. Furthermore, the component includes a homogeneous high porosity (HHP) layer (6) on the second coating (4). Finally, the component includes an abradable layer (8) on the homogeneous high porosity layer (6).

## Description

### Field of the invention

This invention relates to abradable coatings, and more particularly, to the abradable coatings which results in low thermal gradients within a component.

### Background

In turbines, there are components which require a very low clearance between a moving component, such as a blade, and a stationary body of the turbine. Efficiency of turbines is influenced by an amount of fluid that rotates a turbine blade to generate power (rotating torque). If there is a leakage of the fluid driving the turbine blade the efficiency is reduced. Currently there are a few techniques for reducing a fluid leakage from a gap between a stationary part and a rotating part (moving blade) of a turbine. In one such technique, a material which has a property of wearing out (abradability) when a stationary part of the turbine is brought in contact with a moving part of the turbine is applied in a gap between the stationary part and the moving part. An abradable material also prevents the moving part and the stationary part of the turbine from getting damaged when brought into contact, instead the abradable material is worn down. Thus, by providing the abradable material or coating in the gap between the stationary part and the rotating part, the gap is substantially eliminated, a fluid leakage from the gap is minimized, and the efficiency is significantly increased.

Further, when the components are coated with a plurality of coating layers, there is a risk of depletion of the coating layers due to thermal stress. The thermal stress causes an expansion of the coating layers of the component. Due to varying thermal expansion coefficients (TECs) of the coating layers, the component is subjected to stress cracks, reduced ductility, or distortion of the article. Further, there may be a variation in a thermal gradient between the coating layers because of the varying thermal conduction properties of the coating layers. The depletion of the coating layers results in reduced life of the component, which leads to higher maintenance and replacement costs.

Currently, in the state of the art, the component is applied with a high porosity layer prior to applying the abradable layer. Also, an additional layer is deposited between the high porosity layer and the abradable layer. The additional layer leads to deterioration of one or more coating layers by making the component prone to spallation, wherein fragments of the component are ejected due to impact or stress on the component.

Further, there is widespread use of Rhenium in bond coats which are applied on the component. Rhenium being an expensive metal may increase the cost of the bond coats substantially. Therefore, there is a need for a coating system where Rhenium is used sparingly while achieving the same characteristics as the bond coats with substantially higher percentage of Rhenium.

It is therefore necessary that there is a low thermal gradient between the coating layers and the respective TECs of the coating layers do not vary substantially. Also, there is a need of a coating process which is cost effective and reduces the spallation risk of the component.

Accordingly, it is an underlying object of the invention to provide a process for fabricating a component having an abradable coating having lower thermal gradient between the coating layers. The process is also cost effective as coatings comprising Rhenium are used sparingly.

In accordance with the invention, the component comprises a coating for minimizing thermal gradients, wherein the coating comprises, a first bond coating on the substrate, wherein the first bond coating is substantially free from Rhenium. Further, the component includes a second bond coating on the first bond coating. Thereafter, a homogeneous high porosity layer is deposited on the second bond coating. Finally, an abradable layer is deposited on the homogeneous high porosity layer, wherein the first bond coating, the second bond coating, the homogeneous high porosity (HHP) layer and the abradable layer have an effect of a low thermal gradient within the component.

The advantage of the coating process is that there is a low thermal gradient between the coating layers on the component. The low thermal gradient can be attributed to the absence of coating layer between the homogeneous high porosity layer and the abradable layer. Further, the low thermal gradient is the result of the thickness of the coating layers and the composition of the coating layers. Additionally, only one coating layer, which is the second bond coating layer, includes Rhenium, which reduces the cost of fabricating the component.

A further advantage of the invention is that a spallation risk of the component is reduced to the application of the abradable layer directly over the HHP layer. The spallation is reduced because there is no additional coating layer between the HHP layer and the abradable layer.

In accordance with the invention, a thickness (t₁) of the first bond coating is greater than a thickness (t₂) of the second bond coating. The first bond coating, which is a low cost bond coating, is applied at a greater thickness than the second bond coating, which costs significantly higher than the first bond coating. Due to the aforementioned thickness measure, the cost of fabricating the component is reduced while maintaining the durability of the component.

In accordance with the invention, the second coating includes Rhenium. Rhenium enhances the durability and the wear resistance of the component. Additionally, the component can be exposed to higher operating temperatures due to the presence of Rhenium. Furthermore, the oxidation of the component is reduced due to the presence of Rhenium. Therewith, the operational life of the component and the thermal performance of the component are enhanced.

In accordance with an embodiment of the invention, the component can be at least one of a metal, a metallic alloy and a superalloy.

Further the invention includes a method for coating a substrate for minimizing thermal gradients, wherein the method comprises applying a first coat layer on the substrate. Thereafter, a second coat layer is applied upon the first coat layer. Subsequently, a high porosity (HHP) layer is applied upon the second coat layer. Finally, an abradable layer is applied upon the HHP layer.

In accordance with the invention, the abradable layer is deposited directly upon the HHP layer. The aforementioned arrangement enables the coating layers on the component to have a low thermal gradient. The low thermal gradient reduces the thermal stress acting on the component thereby increasing the life and durability of the component.

In accordance with the invention, the first coating and the second coating are applied using at least one of ion plasma deposition process, physical vapour deposition process and a thermal spray deposition process.

The figures illustrate in a schematic manner further examples of the embodiments of the invention, in which:
- FIG 1: depicts a cross sectional view of an exemplary component of the turbo machine;
- FIG 2: illustrates a flowchart of a method for construction of the component referred to in FIG 1

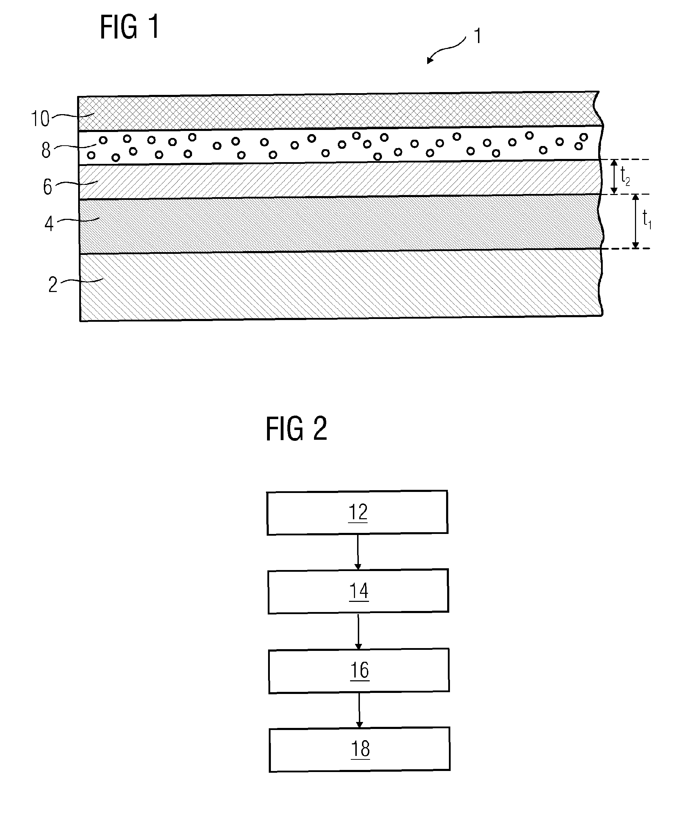

A cross sectional view of an exemplary component 1 for a turbomachine (not shown), in accordance with one or more embodiments of the present invention, is depicted in FIG 1. It may be noted herein that the aforementioned turbomachine can be construed to be a gas turbine, a steam turbine, a turbofan, et cetera. The turbomachine is used in the field of power generation, wherein the chemical energy and/or the mechanical energy of a working fluid is converted into mechanical and/or electrical energy. Further, the component 1 is exposed to extremely high temperatures, for example, greater 1000°C, during the operation of the aforementioned turbomachine.

According to FIG 1, the component 1 includes a substrate 2 over which one or more coating layers, such as coating layers 4, 6, 8 and 10 are deposited. The bulk of the component 1 is composed of the substrate 2. In an embodiment, the substrate 2 is composed of a metal, a metallic alloy and a superalloy. Super alloy may comprise metallic materials, based on iron, nickel or cobalt having yield strengths in excess of 50ksi (345 MPa) and more typically in excess of 100ksi (690 MPa) at 1,000°F (538°C). The substrate 2 is chosen to withstand the extreme temperatures during the operation of the turbomachine.

In accordance with an embodiment of the invention, the substrate 2 is coated with a first coating 4. The first coating 4 is a thermal barrier coating, for example SC 2231, having a very low thermal conductivity. The first coating 4 effectively insulates the substrate 1 from high temperature. Further, the first coating 4 has a thickness t₁. The thickness t₁ of the first coating 4 is determined by the amount of insulation required by the component and the level of thermal gradient.

The chemical composition of the first coating 4, SC2231, is as follows: Nickel - 29 to 31%, Chromium - 27 to 29%, Aluminium - 7 to 8%, Yttrium - 0.5 to 0.7%, Silicon - 0.3 to 0.7% Si, and the remaining comprises Cobalt. It can be noted herein, that the first coating is substantially free from Rhenium. Therefore, the first coating 4 is cost effective. Further, the first coating 4 is coated densely. In an exemplary embodiment, the thickness t₁ of the first coating 4 lies in the range of 100 µm to 300 µm.

In accordance with an embodiment of the invention, a second coating 6 is deposited over of the first coating 4. The second coating is a type of bond coat, for example SC 2464, which insulates the substrate 2 from extreme temperatures. The second bond coat 6 has a thickness t₂. In an embodiment of the invention, thickness t₂ of the second coating 6 is lesser than the thickness t₁ of the first coating 4.

The chemical composition of the second coating 6, for example SC 2464, is as follows: Cobalt - 24 to 26%, Chromium - 16 to 18%, Aluminium - 9.5 to 11%, Yttrium - 0.2 to 0.4%, Rhenium - 1.2 to 1.8%, and the remaining comprises Nickel. It can be noted that the second coating 6 includes Rhenium, which enables the component to function at very high operational temperatures, for example up to 2500°C. Additionally, Rhenium is also resistant to water vapour, which is advantageous in the prevention of oxidation and corrosion of the second coating 6. Furthermore, the excellent wear resistance of Rhenium renders strength and durability to the component 1.

Furthermore, it may be noted herein that the second coating 6 is arranged as a coarse layer on the first coating 4. The coarseness of the second thermal bond coating 12 facilitates the achievement of enhanced bonding with a layer such as a high porosity layer, thereby enhancing the rigidity of the component 1. Further, the thickness t₂ of the second coating 6 is lesser than the first coating 4 which makes the coating cost effective as Rhenium is used sparingly. The thickness t₂ of the second coating 6 is in the range of a 10 to 100 µm.

In an embodiment of the invention, the first coating 4 has a unique chemical reaction with the second coating 6, which the second coating 6 is deposited in the first coating 4. The unique reaction affects the thermal conduction properties of the first coating 4 and the second coating 6.

According to an embodiment of the invention, a homogeneous high porosity (HHP) layer 8 is deposited on the second coating 6. In an embodiment, the HHP layer 8 may be a ceramic based high porosity layer. In an embodiment of the invention, the HHP layer 8 may be generated by heat treatment of a ceramic substance along with other chemicals. The HHP layer 8 has the properties of reduced thermal conductivity and provides better abradable functionality to an abradable layer deposited in the HHP layer 8. The reduced thermal conductivity facilitates in lowering the thermal stress in along the coating layers deposited on the substrate 2.

According to an embodiment of the invention, an abradable layer 10 is deposited on the HHP layer 8. The abradable layer 10 can be composed of, for example, a ceramic material or a metallic material. The abradable layer 10 can be applied using thermal spraying techniques such as, but not limited to, atmospheric plasma thermal spraying, reduced pressure atmosphere plasma thermal spraying, high-speed gas thermally spraying and the like.

Further, the abradable layer 10 is deposited over the HHP layer 8 such that spallation of the component 1 is reduced. Furthermore, the absence of a coating layer between the HHP layer 8 and the abradable layer 10 reduces the risk of the component being fractured. In some embodiments, the abradable layer 10 may be deposited in the HHP layer 8 using heat treatment technique to further reduce the spallation risk.

Furthermore, the aforementioned arrangement of coating layers on the substrate 2 minimizes the thermal gradient within the component 1. The thermal conduction properties of the coating layers have an effect of minimizing the overall thermal gradient of the component 1. Further, due to low thermal gradient the coating layers experience minimal thermal expansion during the operation of the component, which results in extended life of the component.

FIG 2 illustrates a flowchart of a method for construction of the component referred to in FIG 1. At step 12, a first coating is applied on the substrate. The first coating is a bond coating substantially free from Rhenium. At step 14, a second coating is applied upon the first coating. The second coating is coarsely applied on the first coating. Further, the second coating includes Rhenium for better thermal resistance. The first coating and the second coating are applied using at least one of ion plasma deposition process, physical vapour deposition process and a thermal spray deposition process

At step 16, a homogeneous high porosity (HHP) layer is applied on the second coating. The HHP layer has a porous microstructure to minimize the thermal gradient within the component. At step 18, an abradable layer is directly deposited upon the HHP layer to minimize spallation. The arrangement of the layers as mentioned in the method minimizes the thermal gradient within the component. Further, the deposition of the abradable layer directly upon the HHP layer reduces the spallation risk of the component.

Though the invention has been described herein with reference to specific embodiments, this description is not meant to be construed in a limiting sense. Various examples of the disclosed embodiments, as well as alternate embodiments of the invention, will become apparent to persons skilled in the art upon reference to the description of the invention. It is therefore contemplated that such modifications can be made without departing from the embodiments of the present invention as defined.

## Claims

1. A component (1) for a turbomachine, the component (1) comprising a coating, the coating comprising:
a first coating (4) on at least a portion of a surface of a substrate (2), wherein the first coating is substantially free from rhenium;
a second coating (6) on the first coating (4);
a homogeneous high porosity layer (8) on the second coating (6); and
an abradable layer (10) on the homogeneous high porosity layer (8).

2. The component according to claim 1,
wherein a thickness (t₁) of the first coating (4) is greater than a thickness (t₂) of the second coating (6).

3. The component according to claims 1-2,
wherein the second coating (6) includes Rhenium.

4. The component according to claims 1-3,
wherein the abradable layer (10) is deposited on the homogeneous high porosity layer (8) such that spallation of the component is reduced.

5. The component according to claim 1,
wherein the substrate (2) is a metallic material.

6. The component according to claim 1,
wherein the substrate (2) is a metallic alloy.

7. The component according to claim 1,
wherein the substrate (2) is a superalloy.

8. A method of coating a substrate, the method comprising:
- applying a first coating on the substrate;
- applying a second coating upon the first coating;
- applying a high porosity (HHP) layer upon the second coating; and
- applying an abradable layer upon the HHP layer.

9. The method according to claim 8,
wherein the first coat layer and the second coat layer are nickel and chromium based.

10. The method according to claim 8,
wherein an abradable layer is directly deposited upon the HHP layer to minimize spallation.

11. The method according to claim 8,
wherein the first coating and the second coating are applied using at least one of ion plasma deposition process, physical vapour deposition process and a thermal spray deposition process.
